# EUROPEAN PATENT SPECIFICATION

(11) **EP 2 402 483 B1**
(45) Date of publication and mention of the grant of the patent: **21.05.2014**
(21) Application number: 11172085.0
(22) Date of filing: 30.06.2011
(51) Int. Cl.: C23C 14/54

(54) **Apparatus and method for isolating a viewport**
Verfahren und Vorrichtung zur Isolierung eines Ansichtfensters
Appareil et procédé d'isolation d'une fenêtre d'affichage

(30) Priority: 01.07.2010 US 828359
(43) Date of publication of application: 04.01.2012
(73) Proprietor: First Solar Malaysia SDN.BHD, Aman (MY)
(72) Inventor: Little, Edwin Jackson, Arvada, CO Colorado 80004 (US); Pavol, Mark J., Arvada, CO Colorado 80004 (US)
(74) Representative: Thompson, Andrew John

(56) References cited:
- JP-A- 2002 118 063
- JP-A- 2004 031 776
- US-A- 5 413 688

## Description

The present disclosure is directed generally to an apparatus, a method of servicing, and a method of measuring for a coating process.

Line of sight measurements, such as temperature measurements using a pyrometer, are known for use with controlled atmosphere processes, such as sputtering. Such measurements are made through viewports that provide line of sight viewability of a workpiece or other component within the controlled atmosphere.

Generally, in certain coating processes (for example, vapor deposition), a solid material from a vapor is deposited on exposed surfaces of an article within the vapor deposition chamber. The deposition also occurs on other surfaces. The surfaces can include chamber walls, viewports, or other exposed surfaces. Over time, the coating can build up on the chamber walls, viewports, or other exposed surfaces. When buildup occurs on the viewports, measurements through the viewport can become unreliable. Conventional systems require shutdown of the process in order to service the viewport.

US5413688 A discloses a shutter apparatus capable of protecting the interior surface of an evacuable optical coating chamber viewport from the deposition of off-substrate coating material when in the closed position, and exposing the viewport surface to permit viewing through the viewport into the chamber when in the open position. The movement of the shutter between the open and closed positions is accomplished without breaching the chamber seal.

An apparatus and method that provides reduced buildup of coating on a viewport and permits servicing of the viewport without taking the process offline, wherein the apparatus and method may be used in conjunction with the formation of a photovoltaic module would be desired in the art.

In an exemplary embodiment according to the present invention, a shutter apparatus having a viewport, a device positioned for selectively isolating the viewport from a process chamber, and a second chamber positioned between the viewport and the device. The device includes a first position to selectively isolate the viewport from a process chamber and to selectively maintain a predetermined process pressure in the process chamber. The device includes a second position to selectively permit line of sight measurement of the process chamber from the viewport. The second chamber maintains the predetermined process pressure in the process chamber when the device is in the second position.

In another exemplary embodiment according to the present invention, a method for servicing a coating apparatus having an isolatable viewport including providing a shutter apparatus, venting the second chamber, and maintaining the predetermined process pressure in the process chamber during servicing of the coating apparatus. The shutter apparatus includes a viewport, a device positioned for selectively isolating the viewport from a process chamber and a second chamber positioned between the viewport and the device. The device includes a first position to selectively isolate the viewport from a process chamber and to selectively maintain a predetermined process pressure in the process chamber. The device includes a second position to selectively permit line of sight measurement of the process chamber from the viewport. The second chamber maintains the predetermined process pressure in the process chamber when the device is in the second position.

In another exemplary embodiment, a method of measuring a process parameter for a coating process having an isolatable viewport includes providing a shutter apparatus, adjusting pressure in the second chamber, and actuating the device. The shutter apparatus includes a viewport, a device positioned for selectively isolating the viewport from a process chamber; and a second chamber positioned between the viewport and the device. The device includes a first position to selectively isolate the viewport from a process chamber and to selectively maintain a predetermined process pressure in the process chamber. The device includes a second position to selectively permit line of sight measurement of the process chamber from the viewport. The second chamber maintains the predetermined process pressure in the process chamber when the device is in the second position. The process parameter is measured for the coating process when the device is in the second position.

Various aspects and embodiments of the present invention will now be described in connection with the accompanying drawings, in which:
FIG. 1 shows a thin film module mounted on a base according to the disclosure.
FIG. 2 is a diagram of a layer system making up cells of a module according to the disclosure.
FIG. 3 is a process flow diagram for an exemplary process for forming a module according to the disclosure.
FIG. 4 is a schematic view of a plurality of chambers having exemplary shutter apparatuses according to the disclosure.
FIG. 5 is a schematic view of an exemplary shutter apparatus according to the disclosure.
FIG. 6 is a schematic view of an exemplary shutter apparatus according to the disclosure.

Wherever possible, the same reference numbers will be used throughout the drawings to represent the same parts.

Provided is an apparatus and method that provides reduced buildup of coating on a viewport and permits servicing (for example, cleaning, replacing, etc.) of the viewport without taking the process offline. The apparatus and method may be used in conjunction with the formation of a photovoltaic module.

Embodiments of the present disclosure may reduce buildup of coating on viewports, may increase operational capacity by having less downtime for cleaning viewports, may decrease the effect on temperature measurements within a coating chamber, and/or may provide a simple and low cost solution for monitoring and thereby controlling temperature and pressure within a coating chamber.

In the disclosure, when a layer is being described as "adjacent," "on," or "over" another layer or substrate, it is to be understood that the layer can either be directly in contact or that another layer or feature can intervene.

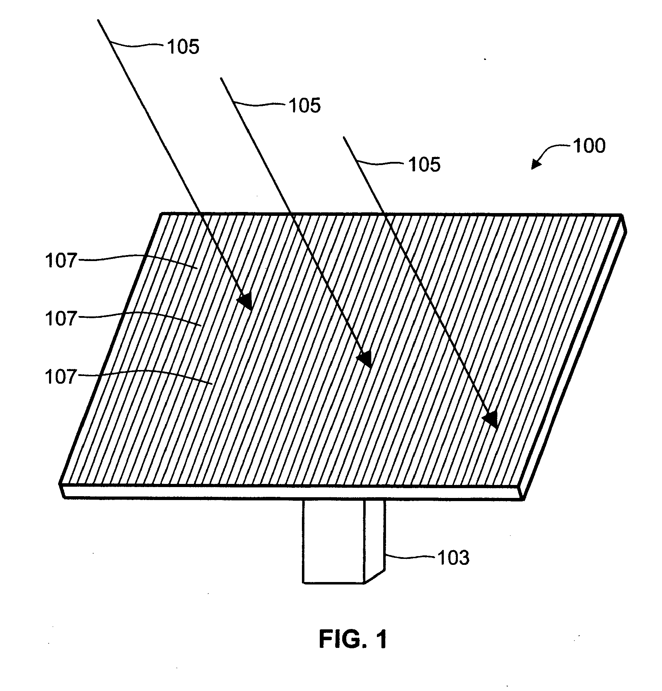

FIG. 1 shows a thin film PV module 100 mounted on a base 103. PV module 100 is arranged to receive light 105. The PV module is divided into a plurality of cells 107 that are arranged in series. Cells 107 are divided by spaces, non-conductive material and/or other structures separating circuits. For example, cells 107 may be isolated from each other by scribes formed by laser scribing. As light 105 shines on PV module 100, electricity is produced. The disclosure is not limited to the arrangement shown and may include other mounting arrangements and/or cells 107. One embodiment of the disclosure includes a thin film CdTe solar photovoltaic (PV) module 100. Such modules are used to produce solar electricity for numerous applications, for example, large ground-mounted systems and rooftop systems on commercial and residential buildings.

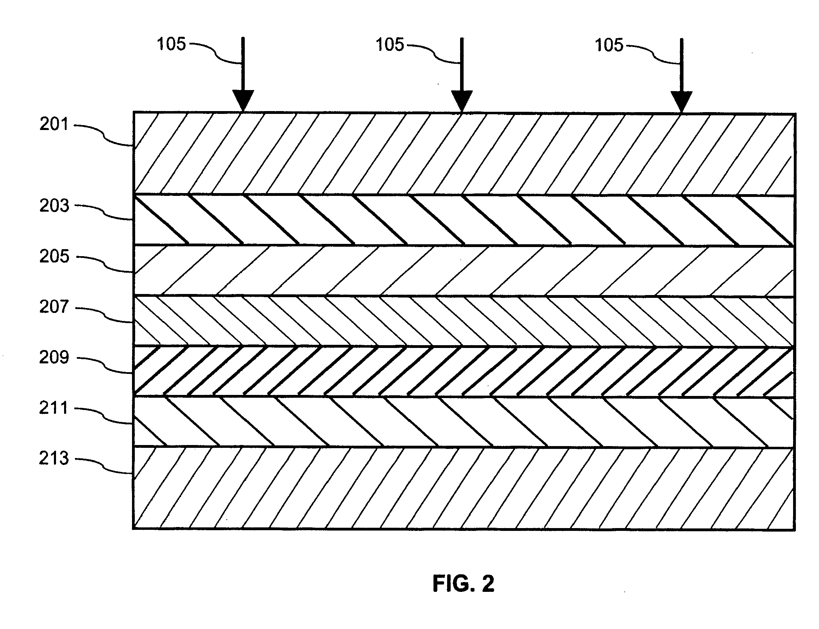

FIG. 2 is a diagram of the layer system forming cells 107 of PV module 100. The layers of cell 107 include a superstrate 201, a first conductive layer 203, a buffer layer 205, a first semiconductor layer 207, a second semiconductor layer 209, a second conductive layer 211 and an encapsulating glass 213. The layers of the cell 107 are arranged to generate and conduct electricity in a usable form when exposed to light 105.

Superstrate 201 is a sheet of high transmission glass onto which thin films are grown. Superstrate 201 receives light 105 (see e.g., FIG. 1) prior to the underlying layers. Superstrate 201 may be a high-transmission, low-iron float glass or any other suitable glass material having a high transmission rate for light 105. In another embodiment, superstrate 201 may also be a high transmission borosilicate glass.

After light 105 passes through superstrate 201, light passes through first conductive layer 203. First conductive layer 203 may be a transparent conductive oxide (TCO), which permits transmission of light 105 with little or no absorption. First conductive layer 203 is also electrically conductive, permitting electrical conduction to provide the series arrangement of cells 107. In one embodiment, the first conductive layer 203 is about 0.3 pm of stoichiometric cadmium stannate (nominally Cd₂SnO₄).

Other suitable conductive layers may include fluorine-doped tin oxide, aluminum-doped zinc oxide, indium tin oxide. First conductive layer 203 may permit passage of light 105 through to the semiconductor layers (e.g., first semiconductor layer 207 and second semiconductor layer 209) while also functioning as an ohmic electrode to transport photogenerated charge carriers away from the light absorbing material.

A buffer layer 205 is adjacent to first conductive layer 203. Buffer layer 205 is more electrically resistive and protects the layers of cell 107 from chemical interactions from the glass and/or interactions which might be incurred from subsequent processing. Inclusion of buffer layer 205 reduces or prevents electrical or other losses that may take place across cell 107 and across module 100. Suitable materials for buffer layer 205 may include zinc oxide containing materials and/or any other suitable barrier material having more electrical resistivity than first conductive layer 203 and capable of protecting the layers of the cell from interactions from the glass or interactions from subsequent processing. In addition, the inclusion of buffer layer 205 permits the formation of a first semiconductor layer 207 which permits photon passage while maintaining a high quality junction capable of generating electricity. In certain embodiments, buffer layer 205 may be omitted or substituted by another material or layer. In one embodiment, buffer layer 205 includes a combination of ZnO and SnO₂ For example, buffer layer 205 may be formed to a thickness of about 0.1 µm thick or less and may include ZnO and SnO₂ in about a one to two (1:2) stoichiometric ratio.

As shown in FIG. 2, first semiconductor layer 207 is adjacent to buffer layer 205 and receives light 105 subsequent to superstrate 201, first conductive layer 203 and buffer layer 205. First semiconductor layer 207 includes a wide bandgap n-type semiconductor material. Suitable semiconductor material for first semiconductor layer 207 includes, but is not limited to CdS, SnO₂ CdO, ZnO, AnSe, GaN, In₂O₂, CdSnO, ZnS, CdZnS or other suitable n-type semiconductor material. In one embodiment, the first semiconductor layer includes CdS. First semiconductor layer 207 may have a thickness from about 0.01 to about 0.1 µm. First semiconductor layer 207 may be formed by chemical bath deposition or by sputtering. First semiconductor layer 207 preferably has a smooth surface and is substantially uniform and free of impurities and pinholes.

First semiconductor layer 207 forms the junction with second semiconductor layer 209 to create the photovoltaic effect in cell 107, allowing electricity to be generated from light 105. Second semiconductor layer 209 may include Cd, CdTe or other p-type semiconductor material when provided with first semiconductor layer 207 provides a photovoltaic effect when exposed to light 105.

As shown in FIG. 2, second semiconductor layer 209 is adjacent first semiconductor layer 207. A second conductive layer 211 is adjacent second semiconductor layer 209 and provides an electrically conductive material that is capable of conducting electricity formed from the combination of first semiconductor layer 207 and second semiconductor layer 209 when exposed to light 105. Although FIG. 2 shows an arrangement of two layers for first semiconductor layer 207 and second semiconductor layer 209, any number of layers, including interstitial layers, may be utilized to provide the photovoltaic effect.

Second conductive layer 211 may be fabricated from any suitable conductive material and combinations thereof. For example, suitable materials include materials including, but not limited to, graphite, metallic silver, nickel, copper, aluminum, titanium, palladium, chrome, molybdenum alloys of metallic silver, nickel, copper, aluminum, titanium, palladium, chrome, and molybdenum and any combination thereof. In one embodiment, second conductive layer 211 may be a combination of graphite, nickel and aluminum alloys.

An encapsulating glass 213 may be adhered adjacent to second conductive layer 211. Encapsulating glass 213 may be a rigid structure suitable for use with the thin films of cell 107. Encapsulating glass 213 may be the same material as superstrate 201 or may be different. In addition, although not shown in FIG. 2, encapsulating glass 213 may include openings or structures to permit wiring and/or connection to cell 107.

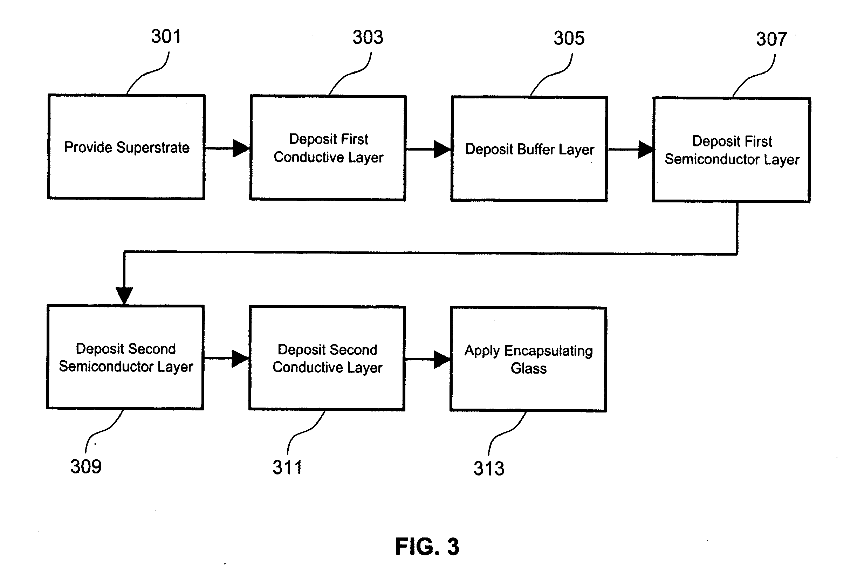

Module 100 and individual cells 107 may include other layers and structures not shown in FIG. 3. For example, superstrate 201 and/or encapsulating glass 213 may include a barrier coating or other structure to reduce or prevent diffusion of impurities into the layers. In addition, encapsulating glass 213 may include an adherent layer to adhere encapsulating glass 213 to the layers. Additional structures that may be present in module 100 and/or cells 107 include scribes, bussing structures, external wiring, and various conventional components useful with thin film and/or PV structures.

FIG. 3 shows a process flow diagram for an exemplary process for forming module 100. The process includes the formation of a thin film stack forming cell 107, wherein the films or layers are formed on superstrate 201 (shown from the top down in FIG. 2).

As shown in the flow diagram of FIG. 3, superstrate 201 is provided (box 301). Superstrate 201 may be fabricated from any suitable material capable of receiving thin films for use as photovoltaic cells 107 and sufficiently transparent to allow transmission of light 105.

Subsequent to providing superstrate 201, first conductive layer 203 is deposited onto superstrate 201 (box 303). First conductive layer 203 is electrically conductive, which permits electrical conduction to provide the series arrangement of cells 107. In one embodiment, first conductive layer 203 is about 0.3 µm of stoichiometric cadmium stannate (nominally Cd₂SnO₄). Other suitable conductive layers may include fluorine-doped tin oxide, aluminum-doped zinc oxide, and/or indium tin oxide. First conductive layer 203 can be formed, for example by direct current (DC) or radio refrequency (RF) sputtering. In one embodiment, first conductive layer 203 is a layer of substantially amorphous Cd₂SnO₄ that is sputtered onto superstrate 201. Such sputtering can be performed from a hot-pressed target containing stoichiometric amounts of SnO₂ and CdO onto superstrate 201 in a ratio of 1 to 2. The cadmium stannate can alternately be prepared using cadmium acetate and tin (II) chloride precursors by spray pyrolysis.

Once first conductive layer 203 is applied, buffer layer 205 may be applied to first conductive layer 203 (box 305). In one embodiment, buffer layer 205 may be formed, for example, by sputtering. In one example, buffer layer 205 may be formed by sputtering from a hot-pressed target containing stoichiometric amounts of about 67 mol % SnO₂ and about 33 mol % ZnO onto first conductive layer 203. As deposited by sputtering, the zinc tin oxide material for buffer layer 205 may be substantially amorphous. Layer 205 may have a thickness between about 200 and 3,000 Angstroms, or between about 800 and 1,500 Angstroms, to have desirable mechanical, optical, and electrical properties. Buffer layer 205 may have a wide optical bandgap, for example about 3.3 eV or more, in order to permit the transmission of light 105.

First semiconductor layer 207 is deposited on buffer layer 205 (box 307). In one embodiment, first semiconductor layer 207 may be formed, for example, by chemical bath deposition or sputtering. First semiconductor layer 207 may be deposited to a thickness of from about 0.01 to 0.1 µm. One suitable material for use as first semiconductor layer 207 is CdS. A suitable thickness for a CdS layer may be from about 500 and 800 Angstroms. First semidconductor layer 207 forms the junction with second semiconductor layer 209 to create the photovoltaic effect in cell 107, allowing it to generate electricity from light 105.

After the formation of first semiconductor layer 207, second semiconductor layer 209 is deposited on first semiconductor layer 207 (box 309). Second semiconductor layer 209 may include Cd, CdTe or other p-type semiconductor material. Second semiconductor layer 209 may be deposited by diffusive transport deposit, sputtering or other suitable deposition method for depositing p-type semiconductor thin film material.

Subsequent to the formation of second semiconductor layer 209, second conductive layer 211 is formed (box 311). Second conductive layer 211 may be fabricated from any suitable conductive material. Second conductive layer 211 may be formed by sputtering, electrodeposition, screen printing, physical vapor deposition (PVD), chemical vapor deposition (CVD) or spraying. In one embodiment, second conductive layer 209 is a combination of graphite that is screen printed onto the surface and nickel and aluminum alloy that is sputtered thereon.

All the sputtering steps described above are suitably magnetron sputtering at ambient temperature under highly pure atmospheres. However, other deposition processes may be used, including higher temperature sputtering, electrodeposition, screen printing, physical vapor deposition (PVD), chemical vapor deposition (CVD) or spraying. In addition, the processing may be provided in a continuous line or may be a series of batch operations. When the process is a continuous process, the sputtering or deposition chambers are individually isolated and brought to coating conditions during each coating cycle and repeated.

Once second conductive layer 211 is formed, encapsulating glass 213 is adhered to second conductive layer 211 (box 313). Encapsulating glass 213 may be a rigid material suitable for use with thin film structures and may be the same material or different material than superstrate 201. Encapsulating glass 213 may be adhered to second conductive layer 211 using any suitable method. For example, encapsulating glass 213 may be adhered to second conductive layer 211 using an adhesive or other bonding composition.

Although not shown in FIG. 3, other processing steps may be included in the process for forming module 100 and cells 107. For example, cleaning, etching, doping, dielectric or other selective insulative material deposition, formation of interstitial layers, scribing, heat treatments, and wiring may also be utilized. For example, wiring and/or bussing devices may be provided to complete the PV circuit (i.e., cells 107 in series arrangement) and to provide connectivity of the PV circuit to a load or other external device.

Scribing may be utilized to form the interconnections between the layers and isolate cells and/or layers of the thin film stack. Scribing may be accomplished using any known techniques for scribing and/or interconnecting the thin film layers. In one embodiment, scribing is accomplished using a laser directed at one or more layers from one or more directions. One or more laser scribes may be utilized to selectively remove thin film layers and to provide interconnectivity and/or isolation of cells 107. In one embodiment, the scribes and layer deposition are accomplished to interconnect and/or isolate cells 107 to provide a PV circuit having cells 107 in a series electrical arrangement.

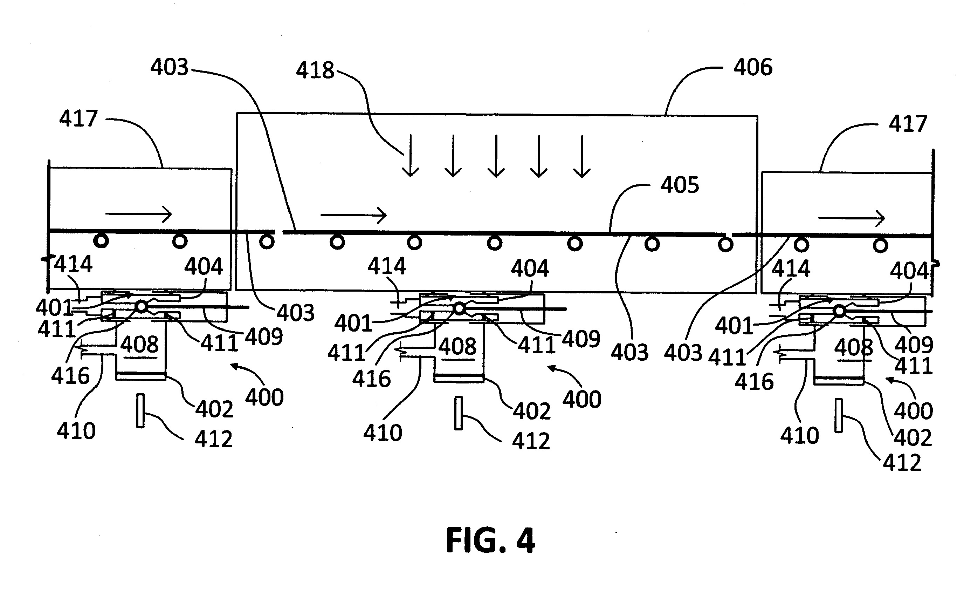

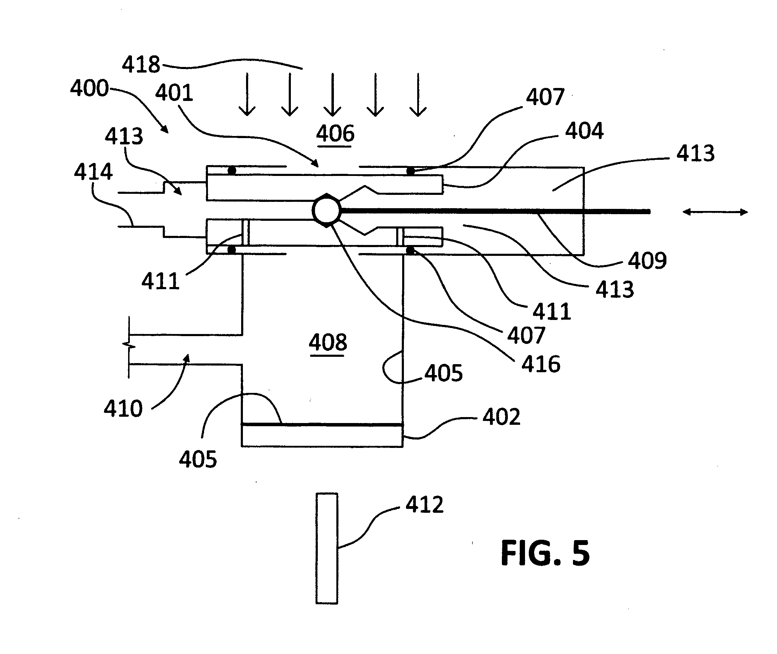

FIG. 4 shows a plurality of heat chambers 417 and process chamber 406 having shutter apparatuses 400. Process chamber 406 may be a vapor deposition chamber. In vapor deposition, a solid material formed from a vapor is deposited on exposed surfaces of an article 403 (see FIG. 5) within chamber 406 thereby forming a coating 405. For example, vapor deposition may be used for coating a glass surface (for example, superstrate 201) with cadmium telluride (box 309 in FIG. 3).

In one embodiment, chamber 406 may have an entrance and an exit permitting articles to enter and exit chamber 406 at predetermined times during the vapor deposition. For example, chamber 406 may be an in-line chamber as part of a substantially continuous manufacturing line. The entrance and the exit may positioned inline before, after, and/or adjacent to heat chambers 417. Heat chambers 417 may include features for maintaining a vacuum before, after, and/or within process chamber 406 during some or all periods of the vapor deposition. In another embodiment, process chamber 406 may be a batch chamber having a fixed volume of space available for application of coating.

Shutter apparatus 400 includes a viewport 402, a device 404 positioned for selectively isolating viewport 402 from process chamber 406, and a second chamber 408 positioned between viewport 402 and device 404, second chamber 408 having a port 410 (as further described below with reference to FIG. 5). Apparatus may be used for measuring temperature within process chamber 406 with a pyrometer 412.

The process can involve monitoring and controlling of various parameters. For example, the duration of the deposition process may be controlled, the amount of vapor provided may be controlled, and the properties of the vapor provided may be controlled. The properties of the vapor provided may include the temperature and pressure. Within process chamber 406, multiple vapors of different temperatures may be provided and/or vapors provided may change temperature upon entering the atmosphere of process chamber 406. Monitoring the temperature within process chamber 406 may be performed by measuring temperature through one or more shutter apparatuses 400 positioned along the walls or other portions of process chamber 406. Generally, chamber 406 may be exposed to pressure from about 10⁻¹⁰ torr to about 5000 torr, 10⁻¹⁰ torr to 1 torr, or 10⁻⁴ torr to about 10⁻³ torr and temperatures between about 100°C and about 800°C.

FIG. 5 shows an alternate embodiment of shutter apparatus 400 for reducing or eliminating buildup of coating 405 on viewport 402. Shutter apparatus 400 includes viewport 402, a device 404 positioned for selectively isolating viewport 402 from process chamber 406, and a second chamber 408 positioned between viewport 402 and device 404. Shutter apparatus 400 may be positioned with all or part of shutter apparatus 400 outside or recessed within process chamber 406. In an exemplary embodiment, device 404, second chamber 408, and viewport 402 are all positioned along the exterior of process chamber 406 and process chamber 406 includes an opening 401 proximal to device 404.

Viewport 402 may be any suitable viewport for measuring temperature within process chamber 406 with pyrometer 412. Viewport 402 is formed of a material that includes optical properties that do not modify the temperature measurement. For example, viewport 402 may be a calcium fluoride window. To measure temperature within process chamber 406, viewport 402 may be subjected to high temperatures and low pressures associated with coating processes. It is desirable that the temperature of viewport 402 be maintained at a predetermined temperature below a detection limit of measurement device 412 to avoid modifying the temperature measurement of article 403.

When measurements are being taken, viewport 402 and/or second chamber 408 may be exposed to vapor from within process chamber 406 thereby contacting and potentially coating viewport 402 and/or second chamber 408. Thus, it is desirable that viewport 402 and second chamber 408 be inert and chemically resistant. To remove coating 405 that builds up on viewport 402 or second chamber 408, viewport 402 and/or second chamber 408 may be removed and cleaned after device 404 is closed (as shown in FIG. 5) and second chamber 408 is vented. Removal and cleaning of viewport 402 and/or second chamber 408 may be performed when process chamber 406 is not operating or when device 404 is positioned for isolating viewport 402 and second chamber 408 (for example, when device 404 is closed). In one embodiment, viewport 402 and/or second chamber 408 may be removed and cleaned while process chamber 406 is vented. After cleaning, second chamber 408 and/or viewport 402 may be reattached.

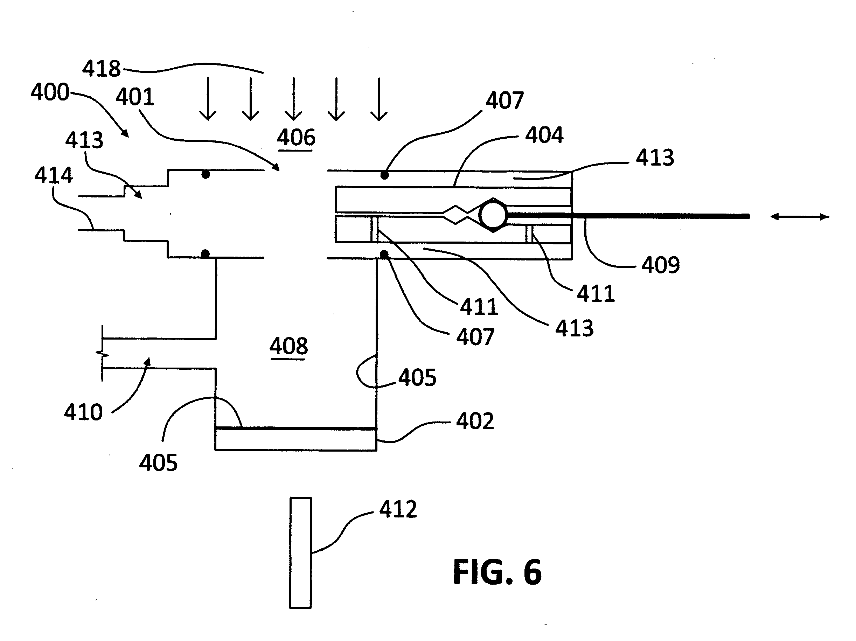

Referring to FIGS. 5 and 6, device 404 may be positioned for selectively isolating viewport 402 from process chamber 406. As used herein, the term "selectively isolating" refers to isolating the atmosphere and line of sight view between viewport 402 and process chamber 406. Device 404 may be any suitable valve, gate, or selectively adjustable device for providing selective adjustment of an opening between process chamber 406 and second chamber 408. For example, device 404 may be a high vacuum gate valve. Device 404 includes a first position (closed) to selectively isolate viewport 402 from process chamber 406 and to selectively maintain a predetermined pressure (or other suitable predetermined process condition) in process chamber 406. In the first position, device 404 may physically block vapor 418 within process chamber 406 from traveling into second chamber 408 and to viewport 402. It is desirable that the physical blocking by device 404 be tight such that little or no vapor can travel from process chamber 406 through device 404 into second chamber 408 when device is closed. For example, one or more seals 407 may be included in apparatus 400. Seal(s) 407 may be o-ring(s) or any suitable device for substantially preventing unintended pressure changes (or other suitable predetermined process condition) within process chamber 406 and/or second chamber 408. Additionally, device 404 may include ports 411 for adjusting pressure within additional regions (for example, region 413 and within chamber 408) to equalize pressure. In one embodiment, device 404 may be a high vacuum gate valve or rotary type flapper valve.

Device 404 further includes a second position (open) to selectively permit line of sight measurement of process chamber 406 from viewport 402. Device 404 may move from the first position to the second position by any suitable mechanism. For example, device 404 may move from the first position to the second position by a rod 409 actuated by any suitable mechanism for adjusting the position of device 404. As device 404 is actuated from the second position (open) to the first position (closed) by rod 409, a cam feature 416 may force seal(s) 407 to be compressed outwardly toward sealing surface. In the second position (open), cam feature 416 may be adjusted by moving rod 409, thereby permitting an open path between process chamber 406 and viewport 402.

It is desirable for the shutter apparatus 400 to be in the second position for a short duration because vapor within process chamber 406 may be traveling into second chamber 408 and to viewport 402 while the device is in the second position. It is further desirable that device 404 open quickly to decrease the duration of time between the shutter apparatus 400 being in the first position (where little or no vapor is likely to travel from process chamber 406 into second chamber 408) and the shutter apparatus 400 being in the second position (where temperature measurements of process chamber 406 may be performed with the pyrometer 412).

In one embodiment, differential pumping may be performed by one or more ports 414 positioned in a region 413 selectively fluidly separated from second chamber 408 and process chamber 406 by device 404. Differential pumping may permit operation of process chamber 406 at lower pressures. Port(s) 414 may reduce or eliminate air (or other gas) entering process chamber 406 by removing the air (or other gas) in region 413 prior to the air (or other gas) traveling to process chamber 406. Port(s) 414 may be vacuum pumped when device 404 is in the first position (closed). In another embodiment, seal(s) 407 may be utilized (along with differential pumping on port(s) 414) to selectively reduce or eliminate traveling of vapor between process chamber 406, into region 413, and second chamber 408. Also, prior to actuating device 404 to the second position (open), pressure within region 413 may be adjusted (for example, to substantially equalize the pressure) in second chamber 408 and process chamber 406. Other suitable methods of differential pumping may additionally or alternatively be used.

Referring to FIG. 5, second chamber 408 is positioned between viewport 402 and device 404 with port 414 being blocked (or not included) and ports 411 being open. Second chamber 408 is adjusted to a pressure substantially equivalent to the predetermined pressure in process chamber 406 prior to device 404 being actuated to the second position (open). The pressure may be adjusted by removing gas from second chamber 408 via port 410 connected to a pump or other suitable mechanism for controlling the pressure of gases. In an exemplary embodiment, port 410 is positioned along the side of second chamber 408. In other embodiments, port 410 may be positioned in other suitable locations on second chamber 408.

While the disclosure has been described with reference to a preferred embodiment, it will be understood by those skilled in the art that various adjustments may be made and equivalents may be substituted for elements thereof without departing from the scope of the disclosure. In addition, many modifications may be made to adapt a particular situation or material to the teachings of the disclosure without departing from the essential scope thereof. Therefore, it is intended that the disclosure not be limited to the particular embodiment disclosed as the best mode contemplated for carrying out this disclosure, but that the disclosure will include all embodiments falling within the scope of the appended claims.

## Claims

1. A shutter apparatus (400) having an isolatable viewport (402), the shutter apparatus (400) comprising:
a viewport (402);
a device (404) positioned for selectively isolating the viewport (402) from a process chamber (406); and
a second chamber (408) positioned between the viewport (402) and the device (404);
wherein the device (404) includes a first position to selectively isolate the viewport (402) from a process chamber (406) and to selectively maintain a predetermined process pressure in the process chamber (406);
wherein the device (404) includes a second position to selectively permit line of sight measurement of the process chamber (406) from the viewport (402); and
wherein the second chamber (408) maintains the predetermined process pressure in the process chamber (406) when the device (404) is in the second position.

2. The apparatus (400) of claim 1, wherein the second chamber (408) is configured for differential pumping.

3. The apparatus (400) of any preceding claim, wherein the second chamber is removable while maintaining the predetermined process pressure in the process chamber (406).

4. The apparatus (400) of any preceding claim, wherein the second chamber includes a port (411), the port (411) being configured to vent the second chamber while maintaining the predetermined process pressure in the process chamber (406).

5. The apparatus (400) of any preceding claim, wherein the viewport (402) is removable while maintaining the predetermined process pressure in the process chamber (406).

6. The apparatus (400) of any preceding claim, wherein the second chamber includes a port (414), the port (414) being configured to adjust the pressure of the second chamber (408).

7. The apparatus (400) of any preceding claim, wherein the device (404) is a high vacuum gate valve, or a rotary type flapper valve.

8. A method for servicing a coating apparatus having an isolatable viewport (402), the method comprising:
providing a shutter apparatus (400) of any one of claims 1 to 7;
venting the second chamber (408); and
maintaining the predetermined process pressure in the process chamber (406) during servicing of the coating apparatus.

9. The method of claim 8, wherein the venting of the second chamber (408) is through a port (411) in the second chamber (408), the port (411) being configured to vent the second chamber (408) while maintaining the predetermined process pressure in the process chamber (406).

10. The method of claim 8 or claim 9, further comprising pumping down the second chamber (408) to a pressure substantially equal to the predetermined process pressure.

11. The method of claim 8, 9 or 10, further comprising actuating the device (404) between the first position and the second position.

12. A method of measuring a process parameter for a coating process having an isolatable viewport (402), the method comprising:
providing a shutter apparatus (400) of any one of claims 1 to 7;
adjusting pressure in the second chamber (408);
actuating the device (404) to the second position; and
measuring the process parameter for the coating process when the device (404) is in the second position.

13. The method of claim 12, wherein measuring the process parameter includes measuring the temperature of an article within the process chamber (406) while the device is in the second position.

14. The method of claim 12 or claim 13, further comprising actuating the device (404) to the first position subsequent to the device (404) being actuated to the second position.

15. The method of claim 12, 13 or 14, further comprising removing a portion of the device (404) while maintaining the predetermined process pressure in the process chamber (406), the portion being the second chamber or the viewport.

16. The method of any one of claims 12 to 15, further comprising differential pumping a region selectively fluidly separated from the second chamber (408) and the process chamber (406) by the device (404).

## Patentansprüche

1. Verschlussvorrichtung (400), aufweisend ein isolierbares Ansichtsfenster (402), wobei die Verschlussvorrichtung (400) Folgendes aufweist:
ein Ansichtsfenster (402);
ein Gerät (404), angeordnet für selektives Isolieren des Ansichtsfensters (402) von einer Prozesskammer (406); und
eine zweite Kammer (408), angeordnet zwischen dem Ansichtsfenster (402) und dem Gerät (404);
wobei das Gerät (404) eine erste Position zum selektiven Isolieren des Ansichtsfensters (402) von einer Prozesskammer (406) und zum selektiven Aufrechterhalten eines im Voraus festgelegten Prozessdrucks in der Prozesskammer (406) aufweist;
wobei das Gerät (404) eine zweite Position zum selektiven Gestatten einer Linie von Sichtmessung der Prozesskammer (406) vom Ansichtsfenster (402) aufweist; und
wobei die zweite Kammer (408) den im Voraus festgelegten Prozessdruck in der Prozesskammer (406) aufrechterhält, wenn sich das Gerät (404) in der zweiten Position befindet.

2. Vorrichtung (400) nach Anspruch 1, wobei die zweite Kammer (408) für ein Differentialpumpen konfiguriert ist.

3. Vorrichtung (400) nach einem der vorhergehenden Ansprüche, wobei die zweite Kammer entfernbar ist, während der im Voraus festgelegte Prozessdruck in der Prozesskammer (406) aufrechterhalten bleibt.

4. Vorrichtung (400) nach einem der vorhergehenden Ansprüche, wobei die zweite Kammer eine Öffnung (411) aufweist, wobei die Öffnung (411) für ein Belüften der zweiten Kammer bei Aufrechterhalten des im Voraus festgelegten Prozessdrucks in der Prozesskammer (406) konfiguriert ist.

5. Vorrichtung (400) nach einem der vorhergehenden Ansprüche, wobei das Ansichtsfenster (402) während des Aufrechterhaltens des im Voraus festgelegten Prozessdrucks in der Prozesskammer (406) entfernbar ist.

6. Vorrichtung (400) nach einem der vorhergehenden Ansprüche, wobei die zweite Kammer eine Öffnung (414) aufweist, wobei die Öffnung (414) für ein Einstellen des Drucks in der zweiten Kammer (408) konfiguriert ist.

7. Vorrichtung (400) nach einem der vorhergehenden Ansprüche, wobei das Gerät (404) ein Hochvakuum-Absperrschieber oder ein Drehklappenventil ist.

8. Verfahren zur Wartung einer Beschichtungsvorrichtung, die ein isolierbares Ansichtsfenster (402) aufweist, wobei das Verfahren Folgendes aufweist;
Bereitstellen einer Verschlussvorrichtung (400) nach einem der Ansprüche 1 bis 7;
Belüften der zweiten Kammer (408); und
Aufrechterhalten des im Voraus festgelegten Prozessdrucks in der Prozesskammer (406) während der Wartung der Beschichtungsvorrichtung.

9. Verfahren nach Anspruch 8, wobei das Belüften der zweiten Kammer (408) durch eine Öffnung (411) in der zweiten Kammer (408) erfolgt, die Öffnung (411) für ein Belüften der zweiten Kammer (408) bei Aufrechterhalten des im Voraus festgelegten Prozessdrucks in der Prozesskammer (406) konfiguriert ist.

10. Verfahren nach Anspruch 8 oder 9, ferner aufweisend ein Herunterpumpen der zweiten Kammer (408) auf einen Druck, der im Wesentlichen gleich dem im Voraus festgelegten Prozessdruck ist.

11. Verfahren nach Anspruch 8, 9 oder 10, ferner aufweisend ein Betätigen des Geräts (404) zwischen der ersten Position und der zweiten Position.

12. Verfahren zum Messen eines Prozessparameters für einen Beschichtungsprozess, der ein isolierbares Ansichtsfenster (402) aufweist, wobei das Verfahren Folgendes aufweist:
Bereitstellen einer Verschlussvorrichtung (400) nach einem der Ansprüche 1 bis 7;
Einstellen des Drucks in der zweiten Kammer (408);
Betätigen des Geräts (404) in die zweite Position; und
Messen des Prozessparameters für den Beschichtungsprozess, wenn sich das Gerät (404) in der zweiten Position befindet.

13. Verfahren nach Anspruch 12, wobei das Messen des Prozessparameters ein Messen der Temperatur eines Gegenstands innerhalb der Prozesskammer (406), während sich das Gerät in der zweiten Position befindet, umfasst.

14. Verfahren nach Anspruch 12 oder 13, ferner aufweisend ein Betätigen des Geräts (404) in die erste Position, nachdem das Gerät (404) in die zweite Position betätigt worden war.

15. Verfahren nach Anspruch 12, 13 oder 14, ferner aufweisend ein Entfernen eines Teils des Geräts (404) bei Aufrechterhalten des im Voraus festgelegten Drucks in der Prozesskammer (406), wobei das Teil die zweite Kammer oder das Ansichtsfenster ist.

16. Verfahren nach einem der Ansprüche 12 bis 15, ferner aufweisend ein Differentialpumpen eines Bereichs, der durch das Gerät (404) selektiv fluidmäßig von der zweiten Kammer (408) und der Prozesskammer (406) getrennt ist.

## Revendications

1. Appareil obturateur (400) ayant une fenêtre isolable(402), l'appareil obturateur (400) comprenant :
une fenêtre (402) ;
un dispositif (404) positionné pour isoler sélectivement la fenêtre (402) d'une chambre de traitement (406) ; et
une seconde chambre (408) positionnée entre la fenêtre (402) et le dispositif (404) ;
dans lequel le dispositif (404) comprend une première position pour isoler sélectivement la fenêtre (402) d'une chambre de traitement (406) et pour maintenir sélectivement une pression de traitement prédéterminée dans la chambre de traitement (406) ;
dans lequel le dispositif (404) comprend une seconde position pour permettre sélectivement la mesure en visibilité directe de la chambre de traitement (406) depuis la fenêtre (402) ; et
dans lequel la seconde chambre (408) maintient la pression de traitement prédéterminée dans la chambre de traitement (406) lorsque le dispositif (404) est dans la seconde position.

2. Appareil (400) selon la revendication 1, dans lequel la seconde chambre (408) est configurée pour un pompage différentiel.

3. Appareil (400) selon l'une quelconque des revendications précédentes, dans lequel la seconde chambre est amovible tout en maintenant la pression de traitement prédéterminée dans la chambre de traitement (406).

4. Appareil (400) selon l'une quelconque des revendications précédentes, dans lequel la seconde chambre comprend un orifice (411), l'orifice (411) étant configuré pour éventer la seconde chambre tout en maintenant la pression de traitement prédéterminée dans la chambre de traitement (406).

5. Appareil (400) selon l'une quelconque des revendications précédentes, dans lequel la fenêtre (402) est amovible tout en maintenant la pression de traitement prédéterminée dans la chambre de traitement (406).

6. Appareil (400) selon l'une quelconque des revendications précédentes, dans lequel la seconde chambre comprend un orifice (414), l'orifice (414) étant configuré pour ajuster la pression de la seconde chambre (408).

7. Appareil (400) selon l'une quelconque des revendications précédentes, dans lequel le dispositif (404) est une valve-vanne à vide poussé ou une valve à clapet de type rotatif.

8. Procédé d'entretien courant d'un appareil de revêtement ayant une fenêtre isolable (402), le procédé comprenant :
la fourniture d'un appareil obturateur (400) selon l'une quelconque des revendications 1 à 7 ;
l'éventement de la seconde chambre (408) ; et
le maintien de la pression de traitement prédéterminée dans la chambre de traitement (406) pendant l'entretien courant de l'appareil de revêtement.

9. Procédé selon la revendication 8, dans lequel l'éventement de la seconde chambre (408) se fait à travers un orifice (411) dans la seconde chambre (408), l'orifice (411) étant configuré pour éventer la seconde chambre (408) tout en maintenant la pression de traitement prédéterminée dans la chambre de traitement (406).

10. Procédé selon la revendication 8 ou la revendication 9, comprenant en outre la vidange de la seconde chambre (408) à une pression sensiblement égale à la pression de traitement prédéterminée.

11. Procédé selon la revendication 8, 9 ou 10, comprenant en outre l'actionnement du dispositif (404) entre la première position et la seconde position.

12. Procédé de mesure d'un paramètre de traitement pour un traitement de revêtement ayant une fenêtre isolable (402), le procédé comprenant :
la fourniture d'un appareil obturateur (400) selon l'une quelconque des revendications 1 à 7 ;
l'ajustement de la pression dans la seconde chambre (408) ;
l'actionnement du dispositif (404) dans la seconde position ; et
la mesure du paramètre de traitement pour le traitement de revêtement lorsque le dispositif (404) est dans la seconde position.

13. Procédé selon la revendication 12, dans lequel la mesure du paramètre de traitement comprend la mesure de la température d'un article à l'intérieur de la chambre de traitement (406) pendant que le dispositif est dans la seconde position.

14. Procédé selon la revendication 12 ou la revendication 13, comprenant en outre l'actionnement du dispositif (404) dans la première position à la suite de l'actionnement du dispositif (404) dans la seconde position.

15. Procédé selon la revendication 12, 13 ou 14, comprenant en outre l'enlèvement d'une partie du dispositif (404) tout en maintenant la pression de traitement prédéterminée dans la chambre de traitement (406), la partie étant la seconde chambre ou la fenêtre.

16. Procédé selon l'une quelconque des revendications 12 à 15, comprenant en outre le pompage différentiel d'une région sélectivement fluidiquement séparée de la seconde chambre (408) et de la chambre de traitement (406) par le dispositif (404).
